# EUROPEAN PATENT APPLICATION

(11) **EP 4 216 418 A1**
(43) Date of publication of application: **26.07.2023**
(21) Application number: 22209954.1
(22) Date of filing: 28.11.2022
(51) Int. Cl.: H02M 1/10, H02M 3/335, H02M 7/48, H03F 3/217, H02M 1/00

(54) **REPEATER OF ALTERNATING AND DIRECT VOLTAGE SIGNAL**

(30) Priority: 21.01.2022 RU 2022101402
(71) Applicant: Antonov, Sergei Ivanovich, 429950 Novocheboksarsk Chu. Resp. (RU)
(72) Inventor: Antonov, Sergei Ivanovich, 429950 Novocheboksarsk Chu. Resp. (RU)
(74) Representative: Benatov, Samuil Gabriel

(57) **Abstract**

The invention relates to electrical engineering. The repeater of alternating and direct voltage signal comprises a signal source, a polarity driver DA2.1, operational amplifiers DA1.1 and DA1.2, positive A2 and negative A3 switches, an active resistor, a transformer and a microcircuit IC1 connected to resistor R7 and capacitor C48, pulses from which are fed to the amplifier through power transistors VT1-VT4 which are connected to the primary winding 1 of transformer T1. The signal source is connected to polarity driver DA2.1, which generates positive or negative voltage. When voltage is positive, the positive switch A2 opens, and energy rectified by one of the secondary windings of the transformer T1 is supplied to smoothing capacitors C17, C18, C19. When voltage at the output of polarity driver DA2.1 is negative, negative voltage is formed, which closes the positive switch and opens the negative switch, and energy from the second secondary winding of transformer T1 is supplied to smoothing capacitors C17, C18, C19. When alternating voltage is applied, the active resistor becomes operational. Technical result - ability to repeat at the output any shape and frequency of input signal, including positive or negative voltage, which makes it possible to amplify audio frequency signals.

## Description

The invention relates to electrical engineering, and it is based on the conversion of energy through the method of pulse width modulation (PWM).

The predominant area of use is radio electronic devices, such as inverters, signal generators of any form, frequency converters, audio frequency power amplifiers, motor drives, uninterruptible power supplies (UPS) with pure sine, alternating or direct voltage sources, including laboratory ones, chargers, "all-in-one" combo devices such as welder-inverter-UPS-DC power supply-charger.

An amplifier with electrodynamic converter at the output and with positive current feedback is known from the prior art, wherein in order to reduce the unevenness of the frequency response, the positive feedback circuit is formed by connecting the emitter of the pre-terminal stage with the midpoint of the divider, composed of converter coil and series-connected inductors and active resistor, the resistance value of which is equal parts of the equivalent parameters of the converter's coil (SU 472439 A1, publ. 30.05.1975).

A power supply with a transformerless input is known from the source SU 1561171 A1, publ. 30.04.1990, comprising mains rectifier with a reactive element, parametric stabilizer, converter of direct voltage to a high-frequency AC voltage, connected in series with the input pins, with a galvanically separated output, as well as a high-frequency rectifier of an additional parametric stabilizer connected to the output pins, wherein in order to increase operational electrical safety, two protective-separating capacitors are inserted into it, a pulse transformer, the primary winding of which is connected through the protective-separating capacitors to the galvanically separated output of the converter of direct voltage to a high-frequency AC voltage, while the secondary winding is connected to the input of the high-frequency rectifier with additional parametric stabilizer.

Selected as the closest analogue is a stabilized voltage converter with digital microcircuits, known from the document RU 2014713 C1, publ. 15.06.1994.

Stabilized voltage converter with digital microcircuits comprises a generator of rectangular voltage with antiphase outputs, a push-pull power amplifier with first and second transistors, a unit for eliminating through currents, a stabilization device, a microcircuit power source and an output transformer, the beginning and end of the primary winding of which are connected to the collectors, respectively, of the first and the second transistors of the power amplifier, the secondary winding is connected through the rectifier to the output of the converter, and the additional winding of the transformer with the middle output is connected through end outputs to the unit for eliminating through currents, characterized in that, in order to increase the efficiency and obtain several stable voltages, first and second open-collector buffer elements are inserted in it, the inputs of these elements are connected to the outputs of the rectangular voltage generator, while the outputs through the first and second current-limiting resistors are connected to the bases of the first and second p-n-p-transistors of the power amplifier, the unit for eliminating through currents is made on the third and fourth p-n-p-transistors, the emitters of all four transistors are connected to the middle output of the additional winding of the output transformer and to the positive polarity output pin of the source for powering the microcircuits, the base of the third transistor through the third and fourth resistors is connected, respectively, to the beginning of the additional winding of the output transformer and to the output of the second buffer element, the base of the fourth transistor through the fifth and sixth resistors is connected, respectively, to the end of the additional winding and to the output of the first buffer element, the collectors of the third and fourth transistors are connected to the bases of the first and second transistors of the power amplifier, the output of the stabilization device, which is made in the form of an adjustable voltage driver of negative polarity, is connected to the middle output of the primary winding of the output transformer, and the secondary winding of this transformer is equipped with tap leads connected to the rectifiers in accordance with the number of required output voltages, and the output of one of the rectifiers is connected through the feedback circuit to the control input of the stabilization device. RU 2014713 C1, 15.06.1994.

The technical problem is inability to give the desired shape of the output signal in different modes of operation.

The technical result of the claimed invention lies in its ability to repeat at the output any shape and frequency of the input signal, including positive or negative voltage, which makes it possible to amplify audio frequency signals.

The technical result is achieved by implementing a repeater of alternating and direct voltage signal, characterized in that it comprises a signal source with input terminals XS1.1 and XS1.2, a polarity driver DA2.1, operational amplifiers DA1.1 and DA1.2, positive A2 and negative A3 switches, a noise rejection filter, an active resistor, a transformer with primary 1 and secondary 2 and 3 windings and a microcircuit IC1 connected to resistor R7 and capacitor C48, the pulses from which are fed to the amplifier through power transistors VT1-VT4, which are connected to the primary winding 1 of the transformer T1, wherein the signal source is connected through the input terminal XS 1.1 and the resistor R116 to the polarity driver DA2.1, which generates a positive or negative voltage at the output, when the voltage is positive, the positive switch A2 opens and the energy rectified by the secondary winding 2 of the transformer T1 will go to smoothing capacitors C17, C18, C19, wherein received, by the smoothing capacitors C17, C18 and C19, voltage is rectified by diode bridge VDS3 and fed to the non-inverting input 3 of the operational amplifier DA1.1, which serves as a feedback circuit formed by resistors R115, R100, R101, R102, R103, when the voltage at the inverting input 2 of the operational amplifier DA1.1 is exceeded, a positive voltage is generated at the output 1 of the operational amplifier DA1.1, which, through the resistor R104 and the diode VD6, is supplied to the input 4 of the microcircuit IC1, when the voltage is negative at the input terminal XS1.1 and positive at the input terminal XS1.2 of the signal source, a negative voltage is generated at the output of the polarity driver DA2.1, which will close the positive switch A2, while the negative switch A3 will open, and the energy from the secondary winding 3 of the transformer T1 will go to smoothing capacitors C17, C18, C19, when there is an alternating voltage at the input of terminals XS1.1 - XS1.2 of the power source, the active resistor is switched on.

The load is connected to the smoothing capacitors through the noise rejection filter.

Resistor R101 is a variable resistor for adjusting the output voltage.

The feedback signal coming to the inverting input 2 of the operational amplifier DA1.1 comes from the signal source through the diode bridge VDS5 and resistor R114 to stabilize the output voltage of the converter of any polarity and shape.

An active resistor (VDS3, R106, VT20, DA1.2) is used to shape the output signal.

The repeater of alternating and direct voltage signal is capable of reversing the polarity of the direct voltage at the output, as well as to repeat and amplify any form of alternating voltage.

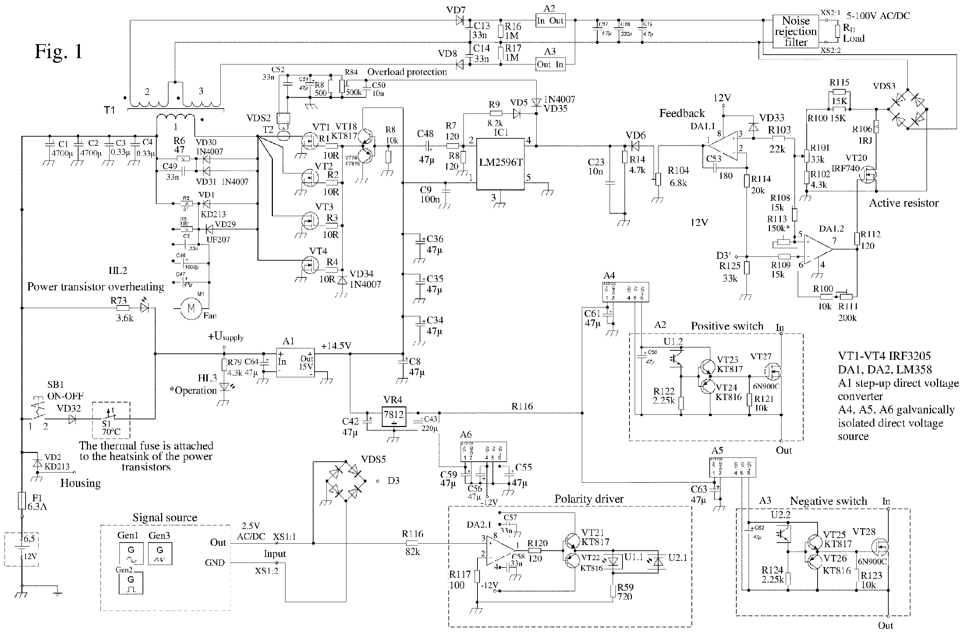

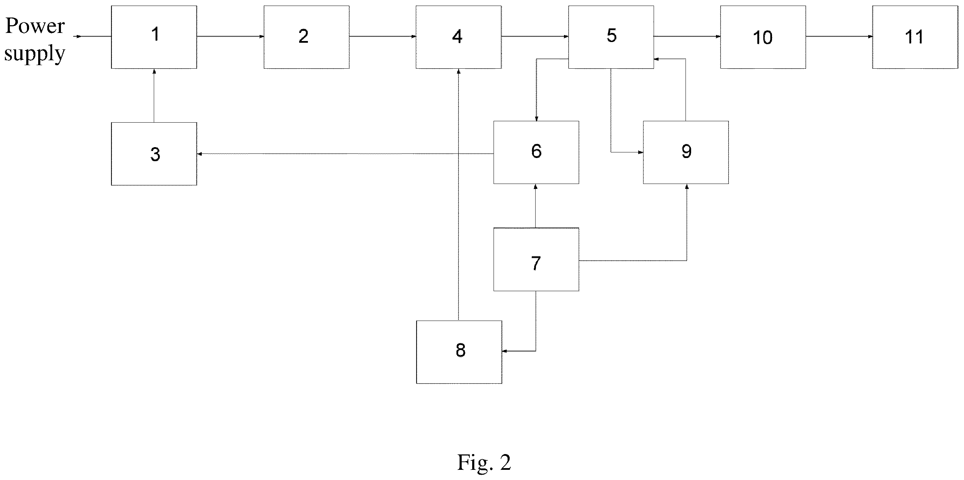

Fig. 1 shows a circuit diagram of a repeater of alternating and direct voltage signal; fig. 2 shows a functional diagram of a repeater of alternating and direct voltage signal.

The principle of operation of the repeater of alternating and direct voltage signal is based on the conversion of energy through the method of pulse-width modulation (PWM).

Figure 1 shows a circuit diagram of a repeater of alternating and direct voltage signal where microcircuit IC1 (LM2596T) is used as PWM controller. At the pin 2 of this microcircuit, rectangular pulses are generated, which are fed through resistor R7 and capacitor C48 to an amplifier assembled on transistors VT18 and VT19. Rectangular pulses, amplified along the current, are used to control power transistors VT1-VT4 connected to the primary winding 1 of the transformer T1. The energy converted by the transformer T1 is taken from the secondary windings 2 and 3, wherein positive pulses are taken from winding 2, and negative pulses - from winding 3. Positive current pulses are rectified by diode VD7, capacitor C13, positive switch A2, and negative ones - by diode VD8, capacitor C14, negative switch A3.

Depending on the incoming external signal to the terminal XS1 of the signal source, the polarity driver DA2.1 generates a positive or negative voltage at the output, this voltage is amplified by the transistors VT21 and VT22 and turns on the light-emitting diode of the opto couplers U1.1 and U2.1. The phototransistor of the positive opto coupler U1.2 opens at positive voltage generated by the polarity driver DA2.1, while the phototransistor of the negative opto coupler U2.1 opens at negative voltage.

A2 and A3 are switches that are opened by the opto coupler, the positive switch A2 assembled on transistors VT27, VT23, VT24, resistors R121, R122 is opened by the opto coupler U1.2, the negative switch A3 assembled on transistors VT28, VT25, VT26, resistors R123, R124 is opened by the opto coupler U2.2.

A positive voltage potential is received at the input terminal XS1.1 of the signal source, -while at XS1.2 - negative. A positive voltage will lead to formation of a positive voltage, relative to the common wire, at the output of the polarity driver DA2.1 and opening of the phototransistor of the opto coupler U1.2, the opto coupler will open the positive switch on the transistor VT27, and the energy rectified with the secondary winding 2 of the transformer T1 will go to the smoothing capacitors C17, C18, C19 through the string diode VD7, capacitor C13, positive switch A2. The voltage, received at the smoothing capacitors C17, C18 and C19, is rectified by the diode bridge VDS3 and the positive voltage is fed to the non-inverting input 3 of the operational device DA1.1 serving as a feedback circuit through resistors R115, R100, R101, R102 (where R101 is a variable resistor for adjusting the output voltage), R103 input 3 of the operational device DA1.1.

The voltage setting for the operational device DA1.1 is the inverting input 2 of the operational device. The signal to it comes from the signal source through the diode bridge VDS5 and resistor R114. As soon as the voltage at input 3 exceeds the voltage at input 2 of the operational device DA1.1, a positive voltage is generated at output 1 of the operational device DA1.1, which, through resistor R104 and diode VD6, is fed to the input 4 of the PWM microcircuit IC1, wherein the microcircuit IC1 reduces the duration of the pulses from the pin 2. Thus, the voltage on the smoothing capacitors stabilizes to the required level. The load is connected to the smoothing capacitors through a noise rejection filter.

Similar is the operation of the circuit in the presence of a negative voltage at the input terminal XS1:1 of the signal source, with the exception of the following, at the output of the polarity driver DA2.1, a negative voltage will be generated relative to the common wire, which will close the positive switch, and will open the negative switch and the energy stored in the secondary winding 3 of the transformer T1 through the diode VD8, the capacitor C14 and the negative switch A3 will go to the smoothing capacitors C17, C18, C19. Onwards, the principle of operation is similar to the described above.

It should be noted that if a positive voltage occurs at the input terminal XS1:1 of the signal source, the device will also generate a positive voltage at the output, at the terminal of the noise rejection filter XS2.1, at the terminal of the noise rejection filter XS2:2 - negative voltage, if a negative voltage is applied at the input terminal of the signal source XS1:1, then a negative voltage will be generated also at the output, at the terminal of the noise rejection filter XS2:1, and at the terminal of the noise rejection filter XS2:2 - positive.

In the case of applying an alternating voltage at the input of the signal source terminal XS1.1, the operational device DA1.1 and the polarity driver DA2.1 work in the same way as described above. Additionally, the "Active resistor" assembled on the transistor VT20, the operational device DA1.2 with feedback and the resistor R106 are included in operation. The operational device DA1.2 compares the setting's voltage at the non-inverting input 6 with the feedback's voltage, i.e. the voltage at the output of the repeater of alternating and direct voltage signal, through the string consisting of diode VDS3, resistors R115, R100, R101, R102, R108 and, if the voltage at the pin 5 of the operational device DA1.2 is greater than that at the input 6, then the operational device generates a positive voltage at output 7, which is fed to the transistor VT20 through the resistor R112 and opens it.

The current flowing through the transistor VT20, the resistor R106 and the diode bridge VDS3 cuts off the excess voltage on the smoothing capacitors C17, C18, C19 giving the shape of the voltage at the output of the noise rejection filter device similar to the input one, but amplified in power. Without the "Active Resistor", the output signal will look more like an incorrect square wave, especially when there is no load.

Positive A2 and negative A3 switches are powered by an independent, galvanically separated source of direct voltage, A4 for the positive switch and A5 for the negative switch.

The polarity driver is powered by a bipolar voltage source A6 ± 12V. Direct voltage sources A4, A5, A6, operational devices DA1.1 and DA1.2, are powered by the stabilizer VR4. Stabilizer VR4 is powered by step-up voltage stabilizer A1.

Transformer T2, diode bridge VDS2, capacitors C52, C51, C50, resistors R8, R84, diode VD35 are used to generate a short circuit or overload voltage. This voltage is fed through the diode VD35 to the input 4 of the PWM microcircuit IC1, wherein the microcircuit IC1 reduces the duration of the pulses at the output, reducing the overall overload or short circuit current.

The external signal must have a low output impedance or to be connected to the power supply terminals XS1:1 and XS1:2 through an isolating transformer, wherein signal penetration to the common negative wire of the device is not allowed.

Diodes VD30, VD31, resistor R6, capacitor C49 and diodes VD1, VD29, resistors R5, R6, capacitors C5, C46, C47 serve as an overvoltage protection damper for transistors VT1-VT4.

For clarity, Fig. 2 shows a functional diagram of a repeater of alternating and direct voltage signal, in which the corresponding positions are as follows:
- 1 -: voltage converter
- 2 -: rectifier
- 3 -: PWM controller
- 4 -: positive and negative switch
- 5 -: smoothing capacitors
- 6 -: feedback amplifier
- 7 -: signal source of any form
- 8 -: polarity driver
- 9 -: active resistor
- 10 -: noise rejection filter
- 11 -: load

## Claims

1. Repeater of alternating and direct voltage signal, **characterized in that** it comprises a signal source with input terminals XS1.1 and XS1.2, a polarity driver DA2.1, operational amplifiers DA1.1 and DA1.2, positive A2 and negative A3 switches, a noise rejection filter, an active resistor, a transformer with primary 1 and secondary 2 and 3 windings and a microcircuit IC1 connected to resistor R7 and capacitor C48, the pulses from which are fed to the amplifier through power transistors VT1-VT4, which are connected to the primary winding 1 of the transformer T1, wherein the signal source is connected through the input terminal XS1.1 and resistor R116 to the polarity driver DA2.1, which generates a positive or negative voltage at the output, the positive voltage opens the positive switch A2 and the energy rectified by the secondary winding 2 of the transformer T1 will go to smoothing capacitors C17, C18, C19, wherein the voltage received at the smoothing capacitors C17, C18 and C19 is rectified by the diode bridge VDS3 and is fed to the non-inverting input 3 of the operational amplifier DA1.1, which serves as a feedback circuit formed by resistors R115, R100, R101, R102, R103, when the voltage at the inverting input 2 of the operational amplifier DA1.1 is exceeded, a positive voltage is generated at the output 1 of the operational amplifier DA1.1, which through the resistor R104 and the diode VD6 is supplied to the input 4 of the microcircuit IC1, when the voltage at the input terminal XS1.1 is negative and the voltage at the input terminal XS1.2 of the signal source is positive, a negative voltage is generated at the output of the polarity driver DA2.1 which will close the positive switch A2, while the negative switch A3 will open, and the energy from the secondary winding 3 of the transformer T1 will go to the smoothing capacitors C17, C18, C19, when there is an alternating voltage at the input of the terminals XS1.1-XS1.2 of the power supply, the active resistor becomes operational.

2. Signal repeater according to claim 1 **characterized in that** the load is connected to smoothing capacitors through a noise rejection filter.

3. Signal repeater according to claim 1 **characterized in that** the resistor R101 is a variable resistor for adjusting the output voltage.

4. Signal repeater according to claim 1 **characterized in that** the feedback signal supplied to the inverting input 2 of the operational amplifier DA1.1 comes from the signal source through the diode bridge VDS5 and resistor R114 in order to stabilize the output voltage of a converter of any polarity and shape.

5. Signal repeater according to claim 1 **characterized in that** an active resistor (VDS3, R106, VT20, DA1.2) is involved in shaping the output signal.

6. Signal repeater according to claim 1 **characterized in that** it is capable of changing the polarity of the direct voltage at the output, as well as repeating and amplifying alternating voltage of any form.
